# EUROPÄISCHE PATENTSCHRIFT

(11) **EP 1 771 053 B1**
(45) Veröffentlichungstag und Bekanntmachung des Hinweises auf die Patenterteilung: **03.04.2013**
(21) Anmeldenummer: 06017890.2
(22) Anmeldetag: 28.08.2006
(51) Int. Cl.: H05K 5/02, H02K 11/00, B60H 1/00

(54) **Kombination einer Steuereinheit mit einem Gehäuse zur Aufnahme derselben**
Combination of a control unit and a housing for the same
Combinaison d'une unité de commande et du boîtier où elle est logée

(30) Priorität: 28.09.2005 DE 102005046390
(43) Veröffentlichungstag der Anmeldung: 04.04.2007
(73) Patentinhaber: Eberspächer Climate Control Systems GmbH & Co. KG, 73730 Esslingen (DE)
(72) Erfinder: Humburg, Michael, 73035 Göppingen (DE); Haber, Bernd, 73249 Wernau (DE); Wetzl, Andreas, 73249 Wernau (DE)
(74) Vertreter: Ruttensperger, Bernhard

(56) Entgegenhaltungen:
- EP-A- 0 241 731
- EP-A- 0 487 761
- EP-A- 1 494 521

## Beschreibung

Die vorliegende Erfindung betrifft eine Kombination einer Steuereinheit mit einem Gehäuse, in welchem diese Steuereinheit aufzunehmen ist, gemäß dem Oberbegriff des Anspruchs 1.

Bei brennstoftbetoriebenen Fahrzeugheizgeräten, z.B. Standheizung oder Zuheizer, sind verschiedene Systembereiche vorhanden, die im Betrieb anzusteuern sind. Dies betrifft beispielsweise eine Dosierpumpe, ein elektrisch zu erregendes Zündorgan oder ein Gebläse zum Fördern der Verbrennungsluft bzw. der Heizluft. Auf Grund der angestrebten möglichst kompakten Baugröße ist es oftmals erforderlich, die einem Systembereich zugeordnete Steuereinheit in einem Gehäuse eines anderen Systembereichs unterzubringen, oder die verschiedenen Steuerfunktionen auf einer einzigen Steuereinheit vorzusehen und dann in ein Gehäuse zu integrieren. Bei einer derartigen Integration einer Steuereinheit in ein Gehäuse, also beispielsweise ein Gebläsegehäuse oder den Wassermantel eines Heizgerätes, ist es erforderlich, die im Betrieb Wärme generierenden elektronischen Bauteile, wie z.B Transistoren, gegen Überhitzung zu schützen, also einen guten Wärmeleitungskontakt zum Gehäuse herzustellen. Dies kann beispielsweise durch Verschraubung erfolgen. Auf Grund des beschränkten Bauraums ist jedoch der Zugang mit Schraubwerkzeugen oftmals nur schwierig zu realisieren.

Die EP 0 241 731 A2 offenbart eine Kombination gemäß dem Oberbegriff des Anspruchs 1. Eine Steuereinheit in Form eines elektronischen Instruments ist an zwei Widerlagerbereichen eines Gehäuses gehalten. Ein erster dieser Widerlagerbereiche umfasst Führungsschienen am Gehäuse, welche in zugeordneten Führungsnuten der Steuereinheit aufgenommen werden, wenn die Steuereinheit in ihre Verstauposition geschoben wird. Der zweite Widerlagerbereich umfasst an dem Gehäuse schwenkbar getragene und durch diesen zugeordnete Federn in eine Arretierstellung vorgespannte Haken. In Zuordnung zu diesen Haken sind an der Steuereinheit Aussparungen vorgesehen, in welche die Haken in der Verstauposition der Steuereinheit einrasten. Um diese Rastwechselwirkung zu lösen, ist ein Hebelmechanismus vorgesehen, welcher bei Verschwenken mit daran vorgesehenen Nockenflächen an an den Haken vorgesehenen Auslöseelementen angreift und somit diese aus ihrer in die Aussparungen eingreifenden Raststellung in eine Freigabestellung verschwenkt.

Die EP 1 494 521 A1 zeigt einen mit einem Elektromotor ausgestatteten Aktuator mit einem Gehäuse, in welches eine den Elektromotor ansteuernde Leiterplatte eingeschoben werden kann. Hierzu sind am Gehäuse Führungsnuten vorgesehen, in welche Randbereiche der Leiterplatte eingeschoben werden. Um zwischen der Leiterplatte und dem Gehäuse des Elektromotors einen Massekontakt herzustellen, ist an der Leiterplatte ein in Z-Form gebogenes Kontaktelement vorgesehen. Mit einem seiner Endschenkel ist dieses Kontaktelement an der Leiterplatte festgelegt und mit dem anderen Endschenkel kann es in Anlagekontakt mit dem Gehäuse des Elektromotors gebracht werden, an welchem es auf Grund seiner elastischen Verformbarkeit unter Vorspannung anliegt.

Es ist die Aufgabe der vorliegenden Erfindung, eine Kombination einer Steuereinheit mit einem Gehäuse zur Aufnahme derselben vorzusehen, bei welcher in einfacher und zuverlässiger Art und Weise die Integration der Steuereinheit in das Gehäuse erlangt werden kann.

Erfindungsgemäß wird diese Aufgabe gelöst durch eine Kombination einer Steuereinheit mit einem Gehäuse zur Aufnahme derselben, wie sie im Anspruch 1 definiert ist. An dem Gehäuse ist ein erster Wideriagerbereich vorgesehen, an welchem die Steuereinheit in einem Einbauzustand an dem Gehäuse abgestützt ist, und ist ein zweiter Widerlagerbereich vorgesehen, an welchem die Steuereinheit im Einbauzustand vermittels eines elastischen Elements abgestützt ist. Eine Blockier/Freigabe-Einheit für das elastische Element deaktiviert dieses in einem Blockierzustand, und in einem Freigabezustand der Blockier/Freibage-Anordnung ist das elastische Element zur Erzeugung einer Abstützwirkung bezüglich des zweiten Widerlagerbereichs freigegeben.

Bei der erfindungsgemäßen Kombination ist die Steuereinheit also nicht durch Verschraubung oder Verklebung im Gehäuse festgelegt, sondern durch die vermittels des elastischen Elements generierte Klemm- bzw. Vorspannwirkung. Um durch dieses Steuerelement beim Zusammenfügen des Gehäuses und der Steuereinheit nicht behindert zu sein, ist das Vorsehen der Blockier/Freigabe-Einheit besonders vorteilhaft.

Um beispielsweise zur Durchführung von Wartungsarbeiten oder Repararturarbeiten die Steuereinheit auch wieder aus dem Gehäuse entnehmen zu können, wird vorgeschlagen, dass die Blockier/Freigabe-Einheit zum Deaktivieren des elastischen Elements aus ihrem Freigabezustand in ihren Blockierzustand bringbar ist.

Eine stabile und gleichwohl einfach zu realisierende Abstützung der Steuereinheit bezüglich des Gehäuses kann dadurch erlangt werden, dass der erste Widerlagerbereich wenigstens zwei Führungs/Abstütz-Abschnitte umfasst, entlang welchen die Steuereinheit zum Bringen derselben in eine Einbaulage bezüglich des Gehäuses bewegbar ist. Dabei kann vorgesehen sein, dass wenigstens ein Führungs/Abstütz-Abschnitt eine nutartige Aussparung umfasst, in welcher ein Trägerelement der Steuereinheit aufnehmbar und führbar ist.

Dabei kann vorgesehen sein, dass wenigstens ein Führungs/Abstütz-Abschnitt eine nutartige Aussparung umfasst, in welcher ein Trägerelement der Steuereinheit aufnehmbar und führbar ist.

Das elastische Element kann eine Feder, beispielsweise eine Blattfeder, sein.

Um die Abstützkraft, welche durch das elastische Element generiert wird, in die Steuereinheit einleiten zu können, wird vorgeschlagen, dass das elastische Element zur Reaktionskrafterzeugung an einem Kraftübertragungselement abgestützt ist und dass die Blockier/Freigabe-Einheit einen an dem Kraftübertragungselement verschiebbaren Blockierschieber umfasst. Auf diese Art und Weise kann bei dem Kraftübertragungselement eine Funktionenintegration realisiert werden. Dabei ist es vorteilhaft, wenn der Blockierschieber zwischen einer Blockierstellung, in welcher das elastische Element deaktiviert ist, und einer Freigabestellung, in welcher das elastische Element zur Erzeugung einer Abstützwirkung freigegeben ist, bewegbar ist.

Beim Zusammenfügen der Steuereinheit mit dem Gehäuse kann beispielsweise so vorgegangen werden, dass die Blockier/Freigabe-Einheit nach Positionierung der Steuereinheit bezüglich des Gehäuses in einer Einbaulage von ihrem Blockierzustand in ihren Freigabezustand bringbar ist und zurück. Es wird hier also zunächst die Steuereinheit in ihrer vorgesehenen Einbaulage positioniert und dann durch Bringen der Blockier/Freigabe-Einheit in ihren Freigabezustand die Arretierwirkung des elastischen Elements bereitgestellt. Alternativ ist es möglich, dass die Blockier/Freigabe-Einheit bei Bewegen der Steuereinheit bezüglich des Gehäuses in eine Einbaulage von ihrem Blockierzustand in ihren Freigabezustand überführt wird. Hier ist also keine weitere Maßnahme erforderlich, die nach dem Positionieren der Steuereinheit in dem Gehäuse zu ergreifen wäre. Der Übergang in den Freigabezustand wird beim Bewegen der Steuereinheit in die Einbaulage erzwungen. Um auch dabei dafür sorgen zu können, dass die Steuereinheit aus dem Gehäuse entnommen werden kann, wird vorgeschlagen, dass die Blockier/Freigabe-Einheit vor dem Bewegen der Steuereinheit aus ihrer Einbaulage heraus von ihrem Freigabezustand in ihren Blockierzustand bringbar ist.

Die Zwangsüberführung der Blockier/Freigabe-Einheit in ihren Freigabezustand kann beispielsweise dadurch erlangt werden, dass an dem Gehäuse ein Anschlag vorgesehen ist, an welchem bei Bewegen der Steuereinheit in die Einbaulage vor Erreichen derselben der Blockierschieber zur Anlage kommt und bei fortgesetzter Bewegung der Steuereinheit von seiner Blockierstellung in seine Freigabestellung gelangt.

Die vorliegende Erfindung wird nachfolgend mit Bezug auf die beiliegenden Zeichnungen detailliert beschrieben. Es zeigt:
- Fig. 1: eine perspektivische Ansicht eines Gehäuses eines Seitenkanalgebläses mit einer darin positionierten Steuereinheit;
- Fig. 2: eine Frontansicht des in Fig. 1 dargestellten Gehäuses mit der darin positionierten Steuereinheit;
- Fig. 3: eine Schnittansicht der in den Fig. 1 und 2 gezeigten Steuereinheit, geschnitten längs einer Linie III - III in Fig. 2;
- Fig. 4: eine vergrößerte Detailansicht eines elastischen Elements und eines Bolckierschiebers.

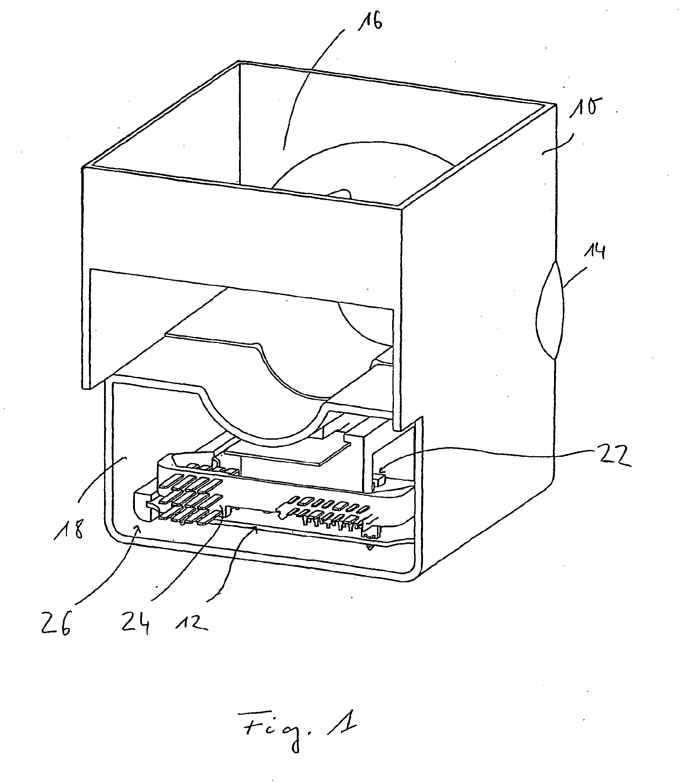

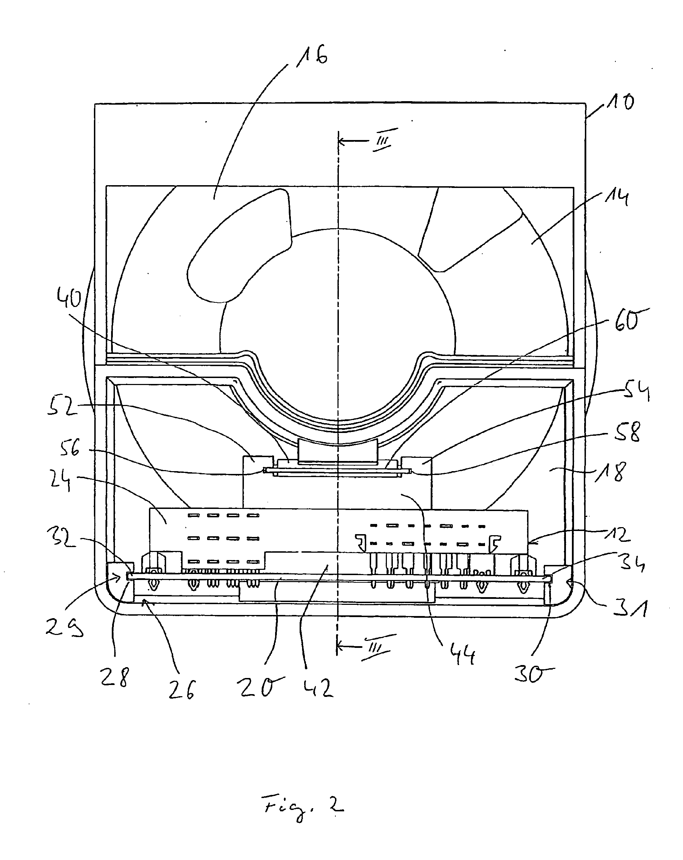

In den Fig. 1 bis 3 ist eine erfindungsgemäße Kombination eines Gehäuses 10 und einer darin aufgenommenen Steuereinheit 12 dargestellt. Dieses Gehäuse 10 ist ein Gehäuse eines Seitenkanalgebläses und weist an einer Seite einen ringartig umlaufenden und an einer axialen Seite offenen Kanal 14 auf. Im zusammengefügten Zustand eines Seitenkanalgebläses ist dieser ringartige Kanal von einem Förderrad überdeckt, das durch einen in dem Innenraum 16 des Gehäuses 10 anzuordnenden Elektromotor angetrieben wird. Seitlich neben dem den Elektromotor aufnehmenden Raum 16 des Gehäuses 10 ist ein zu dem Raum 16 hin abgeschlossener Kammerbereich 18 vorgesehen, in welchem die Steuereinheit 12 aufgenommen und wie im Folgenden noch dargelegt festgelegt ist.

Die Steuereinheit 12, welche beispielsweise zum Steuern des Betriebs des Seitenkanalgebläses oder auch anderer Systemkomponenten eines Fahrzeugheizgerätes dienen kann, weist beispielsweise als Träger eine Leiterplatte 20 auf, aus welcher die verschiedenen nicht weiter detailliert dargestellten elektronischen Komponenten 22 angeordnet sind. Ferner ist an der Leiterplatte 20 eine Steckkontaktleiste 24 getragen, über welche ein Leitungsanschlussstecker in elektrische Verbindung mit der Steuereinheit 12 gebracht werden kann.

Um diese Steuereinheit 12 in einfacher Art und Weise, gleichwohl aber stabil an dem Gehäuse 10 bzw. in dem Kammerbereich 18 anordnen zu können, weist das Gehäuse 10 einen ersten Widerlagerbereich 26 in Form zweier Führungsabschnitte 29, 31 mit in seitlichem Abstand zueinander liegenden Führungsnuten 28, 30 auf. Diese beiden Führungsnuten 28, 30 sind an einander gegenüber liegenden Seiten offen und erstrecken sich parallel zueinander entlang des Kammerbereichs 18. Der gegenseitige Abstand der Führungsnuten 28, 30 und die Erstreckung der Leiterplatte 20 der Steuereinheit 12 sind aufeinander derart abgestimmt, dass die Leiterplatte 20 mit ihren beiden seitlichen Endbereichen 32, 34 in die beiden Nuten 28, 30 eingeschoben und darin verschoben bzw. geführt werden kann.

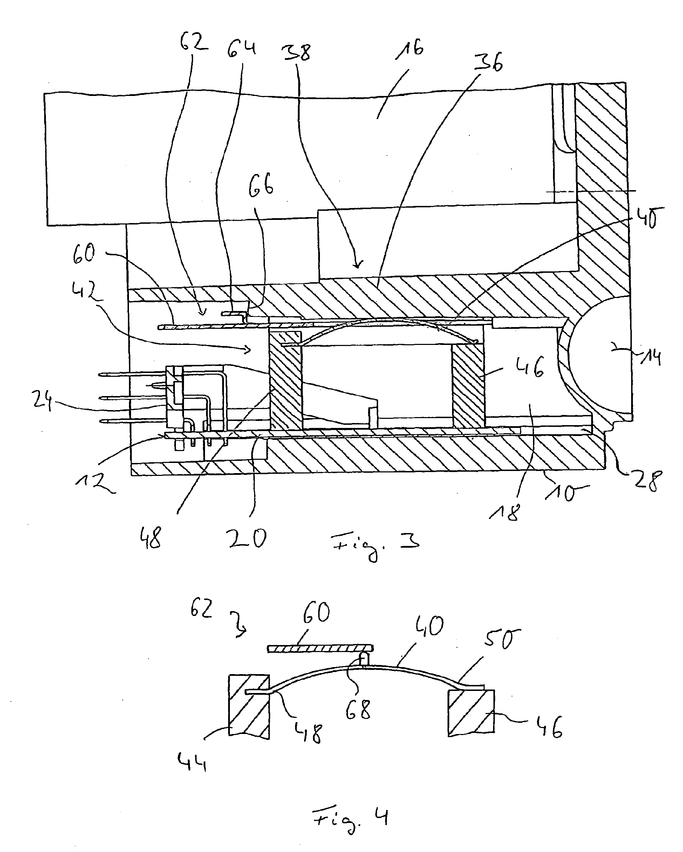

Eine den Raum 16 vom Kammerbereich 18 trennende Wandung 36 bildet einen zweiten Widerlagerbereich 38 an dem Gehäuse 10. An diesem zweiten Widerlagerbereich 38 bzw. der Wandung 36 ist ein hier in Form einer Blattfeder ausgebildetes elastisches Element 40 abgestützt bzw. abstützbar, welches wiederum über ein allgemein mit 42 bezeichnetes Abstützelement an der Leiterplatte 20 der Steuereinheit 12 abgestützt ist. Dieses Abstützelement 42 kann beispielsweise zwei im Wesentlichen parallel zueinander liegende Stege 44, 46 umfassen. Diese Stege 44, 46 sind einerseits an der Leiterplatte 20 getragen. Andererseits trägt der Steg 44 an seinem von der Leiterplatte 20 entfernten Endbereich einen Endbereich 48 der Blattfeder 40 fest, während der andere Endbereich 50 der Blattfeder 40 an dem anderen Steg 46 lediglich abgestützt und somit dort auch verschiebbar ist. An beiden Seiten der Blattfeder 50 sind die beiden Stege 44, 46 durch Verbindungsabschnitte 52, 54 miteinander verbunden. Jeder Verbindungsabschnitt 52, 54 weist eine zum jeweils anderen Verbindungsabschnitt hin offene Nut 56 bzw. 58 auf. Diese Nuten 56, 58 erstrecken sich beispielsweise im Wesentlichen parallel zu den Nuten 28, 30 des ersten Widerlagerbereichs 26. In diesen beiden Nuten 56, 58 des Abstützelements 42 ist ein plattenartiger Blockierschieber 60 verschiebbar aufgenommen. Dieser Blockierschieber 60 kann in Längsrichtung der beiden Nuten 56, 58 verschoben werden. Die Lage des Blockierschiebers 60 bzw. der Nuten 56, 58 ist auf die Formgebung der Blattfeder 40 so abgestimmt, dass in einem Zustand, in welchem der Blockierschieber 60 aus den Nuten 56, 58 nahezu vollständig herausgezogen ist, also ein Zustand, der in Fig. 3 dargestellt ist, die Blattfeder 40 sich über die Höhe des Blockierschiebers 60, gemessen von der Leiterplatte 20 weg, hinauserstreckt. In dem in Fig. 3 dargestellten Einbauzustand bedeutet dies, dass die Blattfeder 40 sich an der Wandung 36 abstützt und durch ihre elastische Vorspannwirkung die Leiterplatte 20 gegen das Gehäuse 10 presst. Auf diese Art und Weise ist die gesamte Steuereinheit fest in dem Gehäuse 10 bzw. dem Kammerbereich 18 getragen und ferner in gutem Wärmeübertragungskontakt mit diesem, ohne dass zusätzliche Befestigungsmittel, wie z.B. Schrauben o.dgl., eingesetzt werden müssten.

Um diesen Einbauzustand zu erlangen, ist die Steuereinheit 12 mit dem Abstützelement 42, der Blattfeder 40 und dem Blockierschieber 60 zunächst in einem Zustand, in dem der Blockierschieber 60, der in Zusammenwirkung mit den Nuten 56, 58 eine Blockier/Freigabe-Anordnung 62 bereitstellt, so weit in die Nuten 56, 58 eingeschoben ist, dass er auch über dem Scheitelbereich der Blattfeder 40 liegt und diese somit verstärkt vorgespannt hält. Die Blattfeder 40 presst somit gegen den Blockierschieber 60 und sichert diesen durch Reibkraftschluss gegen Verschiebung in den Nuten 56, 58. In diesem Blockierzustand der Blockier/Freigabe-Einheit 62 ist also der Blcokierschieber 60 in einer Blockierstellung bezüglich der Blattfeder 40. Die so vorbereitete Steuereinheit 12 wird dann in den Kammerbereich 18 eingeschoben, d.h. die Leiterplatte 20 wird in die Nuten 28, 30 des ersten Widerlagebereichs 26 eingeführt und darin verschoben, beispielsweise bis eine Anschlagposition erreicht ist, die dann einer Einbaulage der Steuereinheit 12 bezüglich des Gehäuses 10 entspricht. Daraufhin kann durch ziehendes Angreifen am Blockierschieber 60 dieser aus seiner Blockierstellung in eine Freigabestellung gezogen werden, in welcher er nunmehr die in Fig. 3 dargestellte Positionierung einnimmt und die Blockier/Freigabe-Anordnung 62 in ihrem Freigabezustand ist. Bei diesem Vorgang kann die Blattfeder 40 sich entspannen und in Anlage am zweiten Widerlagerbereich 38 kommen, so dass dann der vorangehend bereits beschriebene Einbauzustand erlangt ist.

Soll die Steuereinheit 12 aus dem Gehäuse 10 wieder entfernt werden, so wird lediglich der Blockierschieber 60 in die Nuten 56, 58 tiefer hineingeschoben, so dass er die Blattfeder 40 wieder außer Kontakt mit dem zweiten Widerlagerbereich 38 bringt, sie stärker vorspannt und letztendlich die Steuereinheit 12 wieder zum Herausziehen aus den Nuten 28, 30 freigegeben ist.

Mit der erfindungsgemäßen Kombination einer Steuereinheit 12 mit einem Gehäuse 10 ist es also in einfacher Art und Weise möglich, eine derartige Steuereinheit in einem Gehäuse unterzubringen und dort in einem Einbauzustand auch zu arretieren, ohne dass zusätzliche Schraub- oder Befestigungsmittel erforderlich wären. Die Arretierwirkung, also die Haltewirkung für die Steuereinheit 12, wird durch ein elastisches Element, im dargestellten Fall eine Blattfeder 40, realisiert, die im Einbauzustand für eine Verklemmung der Steuereinheit 12 im Gehäuse 10 sorgt. Dieser Einbauzustand kann leicht aufgehoben werden, indem die Blockier/Freigabe-Einheit in ihren Blockierzustand gebracht wird.

Die Fig. 3 zeigt eine Variationsmöglichkeit, im Bereich des Blockierschiebers 60. Man erkennt an diesem eine zungenartige Abbiegung 64, die in Richtung auf den zweiten Widerlagerbereich 38 vorspringt. Beim Bewegen der Steuereinheit 12 in Richtung zu ihrer Einbaulage kommt der zunächst in seiner Blockierstellung positionierte Schieber 60 mit dieser Abbiegung 64 in Anlage an einer Schulter 66 der Wandung 36. Dadurch ist dem Schieber 60 eine weitere Bewegung in den Kammerbereich 18 hinein nicht möglich. Die weiter andauernde Bewegung der Steuereinheit 12 in Richtung zu ihrer Einbaulage führt zu einer zwangsweisen Verschiebung des Blockierschiebers 60 bezüglich des Abstützelements 42 und somit auch bezüglich der Blattfeder 40, so dass bei dieser anhaltenden Bewegung die Blattfeder 40 freigegeben wird und in Anlage am zweiten Widerlagerbereich 38 gelangen kann. Der Einbauzustand wird somit automatisch allein beim Einschieben der Steuereinheit 12 erlangt. Dabei ist vorzugsweise vorgesehen, dass die Blattfeder 40 genau dann freigegeben wird und diese somit dann in Anlage am zweiten Widerlagerbereich 38 gelangt, wenn die Steuereinheit 12 ihre Einbaulage erreicht und somit nicht mehr weiter zu verschieben ist. Dies stellt sicher, dass praktisch keine weitere Verschiebebewegung der Steuereinheit 12 bei gleichzeitiger Belastung durch die Blattfeder 40 erfolgt. Eine möglicherweise an der Steuereinheit 12 vorgesehene Wärmeleitfolie muss sich dann nicht bezüglich des Widerlagerbereichs 26 verschieben und unterliegt somit nicht der Gefahr eine Beschädigung. Soll die Steuereinheit 12 nachfolgend dann entfernt werden, muss lediglich die elastische Abbiegung 64 nach unten gepresst werden, so dass sie nicht mehr Eingriff mit der Schulter 66 ist und der Schieber 60 dann tiefer in der Kammerbereich 18 hingeingeschoben werden kann und in seine Blockierstellung gebracht werden kann.

Ein wesentlicher Vorteil auch dieser Ausgestaltungsform ist, dass die Arretierwirkung der Blattfeder 40 erst im Wesentlichen dann wirksam wird, wenn die Steuereinheit 12 faktisch in ihrer Einbaulage ist. Dies erleichtert das Einschieben und sorgt dafür, dass eine möglicherweise vorhandene Wärmekontaktfolie o.dgl. beim Einschieben durch übermäßige Reibwechselwirkung nicht beschädigt wird.

In Fig. 4 ist eine Abwandlung gezeigt, bei welcher an der Blattfeder 40 ein schneidenartiges Presselement 68 vorgesehen ist. Im Blockierzustand der Blockier/Freigabe-Einheit 62 presst dieses gegen den Blockierschieber 60. Im Freigabezustand presst dieses Presselement 68 gegen den zweiten Widerlagerbereich 38 und sorgt auf Grund seiner geringeren Kontaktfläche und der schneidenartigen Anlagewechselwirkung für eine weiter erhöhte Stabilität bei der Arretierung der Steuereinheit 12. Durch die Zusammenwirkung des Blockierschiebers 60 mit dem Presselement 68 wird sichergestellt, dass der Übergang vom Blockierzustand zum Freigabezustand spontaner auftritt, so dass tatsächlich dieses Presselement 68 auch erst dann in Anlage am zweiten Widerlagerbereich 38 kommt, wenn die Steuereinheit 12 in ihrer Einbaulage ist. Weitere Bewegungen sind dann im Wesentlichen nicht mehr erforderlich.

Es sei abschließend darauf hingewiesen, dass selbstvertsändlich die Steuereinheit 12 an Stelle der Leiterplatte 20 als an dem Gehäuse 10 getragenes Bauelement auch ein anderes Bauteil, beispielsweise einen speziell dafür vorgesehenenen Rahmen, aufweisen kann, der dann den Träger bildet und die Abstützung bezüglich des Gehäuses 10 im ersten Widerlagerbereich 26 realisiert.

## Patentansprüche

1. Kombination einer Steuereinheit (12) mit einem Gehäuse (10) zur Aufnahme derselben, wobei an dem Gehäuse (10) ein erster Widerlagerbereich (26) und ein zweiter Widerlagerbereich (38) vorgesehen sind, an welchen die Steuereinheit (12) in einem Einbauzustand an dem Gehäuse (10) abgestützt ist,
**gekennzeichnet durch** ein bei Herstellung des Einbauzustandes zusammen mit der Steuereinheit (12) bezüglich des Gehäuses (10) bewegbares elastisches Element (40), über welches die Steuereinheit (12) im Einbauzustand am zweiten Widerlagerbereich (38) abgestützt und **durch** Klemmwirkung am Gehäuse (10) festgelegt ist, ferner umfassend eine bei Herstellung des Einbauzustandes zusammen mit der Steuereinheit (12) bezüglich des Gehäuses (10) bewegbare Blockier/Freigabe-Einheit (62) für das elastische Element (40), wobei die Blockier/Freigabe-Einheit (62) in einem Blockierzustand das elastische Element (40) deaktiviert und wobei in einem Freigabezustand der Blockier/Freibage-Einheit (62) das elastische Element (40) zur Erzeugung einer Abstützwirkung bezüglich des zweiten Widerlagerbereichs (38) freigegeben ist.

2. Kombination nach Anspruch 1,
**dadurch gekennzeichnet, dass** die Blockier/Freigabe-Einheit (62) zum Deaktivieren des elastischen Elements (40) aus ihrem Freigabezustand in ihren Blockierzustand bringbar ist.

3. Kombination nach Anspruch 1 oder 2,
**dadurch gekennzeichnet, dass** der erste Widerlagerbereich (26) wenigstens zwei Führungs/Abstütz-Abschnitte (29, 31) umfasst, entlang welchen die Steuereinheit (12) zum Bringen derselben in eine Einbaulage bezüglich des Gehäuses (10) bewegbar ist.

4. Kombination nach Anspruch 3,
**dadurch gekennzeichnet, dass** wenigstens ein Führungs/Abstütz-Abschnitt (29, 31) eine nutartige Aussparung (28, 30) umfasst, in welcher ein Trägerelement (10) der Steuereinheit (12) aufnehmbar und führbar ist.

5. Kombination nach einem der Ansprüche 1 bis 4,
**dadurch gekennzeichnet, dass** das elastische Element (40) eine Feder umfasst.

6. Kombination nach Anspruch 5,
**dadurch gekennzeichnet, dass** die Feder eine Blattfeder ist.

7. Kombination nach einem der Ansprüche 1 bis 6,
**dadurch gekennzeichnet, dass** das elastische Element (40) zur Reaktionskrafterzeugung an einem Kraftübertragungselement (42) abgestützt ist und dass die Blockier/Freigabe-Einheit (62) einen an dem Kraftübertragungselement (42) verschiebbaren Blockierschieber (60) umfasst.

8. Kombination nach Anspruch 7,
**dadurch gekennzeichnet, dass** der Blockierschieber (60) zwischen einer Blockierstellung, in welcher das elastische Element (40) deaktiviert ist, und einer Freigabestellung, in welcher das elastische Element (40) zur Erzeugung einer Abstützwirkung freigegeben ist, bewegbar ist.

9. Kombination nach einem der Ansprüche 1 bis 8,
**dadurch gekennzeichnet, dass** die Blockier/Freigabe-Einheit (62) nach Positionierung der Steuereinheit (12) bezüglich des Gehäuses (10) in einer Einbaulage von ihrem Blockierzustand in ihren Freigabezustand bringbar ist und zurück.

10. Kombination nach einem der Ansprüche 1 bis 8,
**dadurch gekennzeichnet, dass** die Blockier/Freigabe-Einheit (62) bei Bewegen der Steuereinheit (12) bezüglich des Gehäuses (10) in eine Einbaulage von ihrem Blockierzustand in ihren Freigabezustand überführt wird.

11. Kombination nach Anspruch 10,
**dadurch gekennzeichnet, dass** die Blockier/Freigabe-Einheit (62) vor dem Bewegen der Steuereinheit (12) aus ihrer Einbaulage heraus von ihrem Freigabezustand in ihren Blockierzustand bringbar ist.

12. Kombination nach Anspruch 8 und einem der Ansprüche 10 oder 11,
**dadurch gekennzeichnet, dass** an dem Gehäuse (10) ein Anschlag (66) vorgesehen ist, an welchem bei Bewegen der Steuereinheit (12) in die Einbaulage vor Erreichen derselben der Blockierschieber (60) zur Anlage kommt und bei fortgesetzter Bewegung der Steuereinheit (12) von seiner Blockierstellung in seine Freigabestellung gelangt.

## Claims

1. Combination of a control unit (12) with a housing (10) for receiving the latter, a first abutment area (26) and a second abutment area (38) being provided at said housing (10), where the control unit (12) is supported at the housing (10) in a mounted state,
**characterized by** an elastic element (40) which is movable in relation to the housing (10) together with the control unit (12) when realizing the mounted state, by means of which in the mounted state the control unit (12) is supported at the second abutment area (38) and fixed at the housing (10) by a clamping effect, further comprising a blocking/releasing unit (62) for the elastic element (40) which is movable in relation to the housing (10) together with the control unit (12) when realizing the mounted state, wherein said blocking/releasing unit (62) deactivates the elastic element (40) in a blocking state and wherein in a release state of said blocking/releasing unit (62) the elastic element (40) is released for realizing a support effect in relation to said second abutment area (38).

2. Combination according to claim 1,
**characterized in that** said blocking/releasing unit (62) can be brought from its release state into its blocking state for deactivating said elastic element (40).

3. Combination according to claim 1 or 2,
**characterized by** said first abutment area (26) comprising at least two guiding/support sections (29, 31) along which said control unit (12) is movable for taking the latter into a mounting position in relation to housing (10).

4. Combination according to claim 3,
**characterized by** at least one guiding/support section (29, 31) comprising a groove-like recession (28, 30) wherein a carrier element (10) of said control unit (12) can be received and guided.

5. Combination according to one of claims 1 to 4,
**characterized by** said elastic element (40) comprising a spring.

6. Combination according to claim 5,
**characterized by** said spring being a leaf spring.

7. Combination according to one of claims 1 to 6,
**characterized by** said elastic element (40) being supported at a force transmission element (42) for creating a reaction force and by said blocking/releasing unit (62) comprising a blocking slide (60) which is movable at said force transmission element (42).

8. Combination according to claim 7,
**characterized by** said blocking slide (60) being movable between a blocking position where the elastic element (40) is deactivated and a release position where the elastic element (40) is released for creating a support effect.

9. Combination according to one of claims 1 to 8,
**characterized by** said blocking/releasing unit (62) being transferrable from its blocking state to its release state and vice versa after positioning of said control unit (12), in relation to housing (10), in a mounting position.

10. Combination according to one of claims 1 to 8,
**characterized by** said blocking/releasing unit (62) being transferred from its blocking state to its release state when moving said control unit (12) in relation to housing (10) into a mounting position.

11. Combination according to claim 10,
**characterized in that** said blocking/releasing unit (62) can be brought from its release state into its blocking state before moving said control unit (12) out of its mounting position.

12. Combination according to claim 8 and one of claims 10 or 11,
**characterized by** an abutment (66) being provided at said housing (10) against which during movement of said control unit (12) into said mounting position, and prior to reaching the latter, said blocking slide (60) comes into abutment and during continued movement of said control unit (12) moves from its blocking position to its release position.

## Revendications

1. Ensemble d'une unité de contrôle (12) avec un boîtier (10) pour recevoir cette dernière, une première zone de jointure (26) et une deuxième zone de jointure (38) étant prévues au boîtier (10), contre lesquelles l'unité de contrôle (12) est, dans un état de montage, supportée au boîtier (10),
**caractérisé par** un élément élastique (40), mobile en relation au boîtier (10) avec l'unité de contrôle (12) lors de la réalisation de l'état de montage, par lequel l'unité de contrôle (12) est, dans l'état de montage, supportée à la deuxième zone de jointure (38) et fixée au boîtier (10) par un effet de serrage, comprenant en outre une unité de blocage/relâchement (62), mobile en relation au boîtier (10) avec l'unité de contrôle (12) lors de la réalisation de l'état de montage, pour l'élément élastique (40), l'unité de blocage/relâchement (62) désactivant l'élément élastique (40) dans un état de blocage et l'élément élastique (40) étant relâché dans un état de relâchement de l'unité de blocage/relâchement (62) pour créer un effet de support relatif à la deuxième zone de jointure (38).

2. Ensemble selon la revendication 1,
**caractérisé par** l'unité de blocage/relâchement (62) pouvant être mise de son état de relâchement à son état de blocage pour désactiver l'élément élastique (40).

3. Ensemble selon la revendication 1 ou 2,
**caractérisé par** la première zone de jointure (26) comprenant au moins deux sections de guidage/support (29, 31), le long desquelles l'unité de contrôle (12) est mobile pour mettre ces dernières dans une position de montage en relation au boîtier (10).

4. Ensemble selon la revendication 3,
**caractérisé par** au moins une section de guidage/support (29, 31) comprenant un creux en forme de rainure (28, 30) dans lequel un élément de support (10) de l'unité de contrôle (12) peut être reçu et guidé.

5. Ensemble selon une des revendications 1 à 4,
**caractérisé par** l'élément élastique (40) comprenant un ressort.

6. Ensemble selon la revendication 5,
**caractérisé par** le ressort étant un ressort à lames.

7. Ensemble selon une des revendications 1 à 6,
**caractérisé par** l'élément élastique (40) étant supporté à un élément de transfert de force (42) pour générer une force de réaction et par l'unité de blocage/relâchement (62) comprenant une glissière de blocage (60) déplaçable à élément de transfert de force (42).

8. Ensemble selon la revendication 7,
**caractérisé par** la glissière de blocage (60) étant mobile entre une position de blocage dans laquelle l'élément élastique (40) est désactivé et une position de relâchement dans laquelle l'élément élastique (40) est relâché pour créer un effet de support.

9. Ensemble selon une des revendications 1 à 8,
**caractérisé en ce que** l'unité de blocage/relâchement (62) peut, après le positionnement de l'unité de contrôle (12) relatif au boîtier (10) dans une position de montage, être amenée de l'état de blocage à son état de relâchement et vice versa.

10. Ensemble selon une des revendications 1 to 8,
**caractérisé par** l'unité de blocage/relâchement (62) étant après le positionnement de l'unité de contrôle (12), relatif au boîtier (10), dans une position de montage amené de son état de blocage à son état de relâchement.

11. Ensemble selon la revendication 10,
**caractérisé par** l'unité de blocage/relâchement (62) pouvant être amenée de son état de blocage à son état de relâchement avant de sortir l'unité de contrôle (12) de sa position de montage.

12. Ensemble selon la revendication 8 et une des revendications 10 ou 11,
**caractérisé par** un arrêt (66) étant prévu au boîtier (10) où, quand l'unité de contrôle (12) est amenée dans la position de montage et avant d'atteindre cette dernière, la glissière de blocage (60) s'arrête et où dans le cas d'un mouvement continu de l'unité de contrôle (12) la glissière de blocage est amenée de sa position de blocage à sa postion de relâchement.
